Europäisches Patentamt

European Patent Office ·

Office européen des brevets

(19)

(11) Veröffentlichungsnummer: **0 022 176**
B1

(12) **EUROPÄISCHE PATENTSCHRIFT**

(45) Veröffentlichungstag der Patentschrift:
12.01.83

(21) Anmeldenummer: 80103083.4

(22) Anmeldetag: 03.06.80

(51) Int. Cl.³: **H 05 K 7/06,** H 05 K 1/14,
H 05 K 7/12, H 01 L 23/54,
H 05 K 3/30

(54) **Modul für Schaltungschips.**

(30) Priorität: 29.06.79 US 53660

(43) Veröffentlichungstag der Anmeldung:
14.01.81 Patentblatt 81/2

(45) Bekanntmachung des Hinweises auf die Patenterteilung:
12.01.83 Patentblatt 83/2

(84) Benannte Vertragsstaaten:
BE DE FR GB SE

(56) Entgegenhaltungen:
FR-A-1 520 294
GB-A-1 278 380
US-A-3 949 274

(73) Patentinhaber: International Business Machines
Corporation, Armonk, N.Y. 10504 (US)

(72) Erfinder: Thompson, David Allen, Twin Lake Village,
South Salem New York 10590 (US)

(74) Vertreter: Rudack, Günter O., Dipl.-Ing., c/o
International Business Machines Corporation Zurich
Patent Operations Säumerstrasse 4,
CH-8803 Rüschlikon (CH)

ACTORUM AG

## Modul für Schaltungschips

Die Erfindung betrifft einen Modul für Schaltungschips, dessen Stromversorgung über Strukturen paralleler Stromleiter mit hoher gegenseitiger Kapazität erfolgt, wie dies im Oberbegriff des Anspruchs 1 ausgeführt und im US-Patent Nr. 3949274 beschrieben ist.

Es sind bereits vielerlei Ausführungen von Moduln zur Vereinigung von Schaltungschips (Mikrobaustein) bekannt, worunter solche mit einem Chipträger. Darin sind mehrere parallele Stromleiterplatten übereinandergeschichtet. Diese liegen zugleich parallel zu jener Oberfläche, auf der die Chipkontakte elektrisch mit Anschlusspunkten verbunden sind. Die Leiterplatten weisen grosse Flächen auf und zwischen ihnen liegt dielektrisches Material, so dass diese Struktur hohe gegenseitige Kapazitäten einschliesst. Ihr Nachteil liegt jedoch in der grossen Zahl Verbindungen zwischen den Leiterplatten und den Chips, deren Herstellung kompliziert ist. Der Grund dazu liegt darin, dass viele Verbindungen quer durch parallele Platten hindurch bis zu den Anschlusspunkten auf der obersten Fläche des Chipträgers geführt werden müssen.

Im US-Patent Nr. 3562592 wird ein Modul beschrieben, der auf seiner Oberfläche dünnschichtige Leiterbahnen im Gegensatz zu stromführenden Leiterplatten aufweist. Zur Erleichterung der Leitungsführung zu den Chipkontakten sind die Chips mit ihren Kanten in einem Winkel von 45° zu den Leiterbahnen angeordnet.

Es ist daher Aufgabe der vorliegenden Erfindung, eine wirkungsvolle, kompakte Modulstruktur für VLSI-Chips mit hoher Packungsdichte aufzuzeigen, bei der elektrische Störungen, hervorgerufen durch simultanes Arbeiten zahlreicher Schaltkreise, weitgehend unterdrückt werden. Dies gelingt vorwiegend dank hoher Kapazität zwischen den Stromleitern bis ganz nahe an die Chips heran, obwohl mehrere Versorgungsleiter mit jedem Chip zu verbinden sind. Die Störunterdrückung muss auch für schnellschaltende Rechnereinrichtungen wirksam und gleichzeitig der Modul einfach und leicht herstellbar sein.

Die Erfindung, welche diese Aufgabe löst und im Patentanspruch 1 definiert ist, wird nachstehend in allen Einzelheiten anhand eines Ausführungsbeispiels erläutert. In den zugehörigen Zeichnungen zeigen:

Fig. 1 die perspektivische Ansicht eines Moduls mit einer Struktur zur Vereinigung einer grossen Zahl von Mikrobausteinen (Chips) mit sehr hohem Integrationsgrad (VLSI),

Fig. 2A die Ansicht von rechts einer einzelnen Leiterplatte der Stromversorgung, wie sie in Fig. 1 ersichtlich sind,

Fig. 2B die Ansicht von unten derselben Leiterplatte der Stromversorgung von Fig. 2A,

Fig. 3 die perspektivische Draufsicht auf das Trägersubstrat eines Moduls von Fig. 1,

Fig. 4 die Draufsicht auf Substrat, Chips und geschichtete Leiterplatten der Stromversorgung gemäss Fig. 1,

Fig. 5 die Teilansicht des Querschnitts durch Leiterplatten, Dielektrikumschichten und Flachkabel der Fig. 1 und 4 entlang der Linie 5-5 in Fig. 7,

Fig. 6 die Frontansicht des Moduls von Fig. 1, und

Fig. 7 einen Querschnitt entlang der Linie 7-7 in den Fig. 4 und 5 der oberen metallischen Kontaktschichten und der oberen Kanten der Leiterplatten der Stromversorgung, der vergrössert in einer bevorzugten Ausführung die indirekte Verbindung der Leiterplatten über diese Kontaktschichten mit den Schaltungschips darstellt.

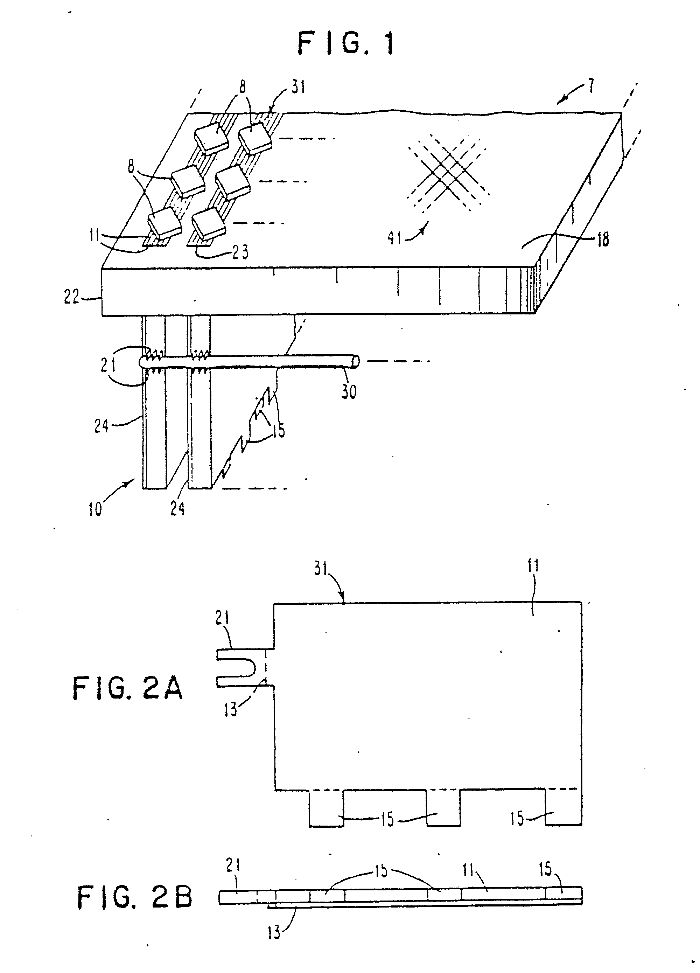

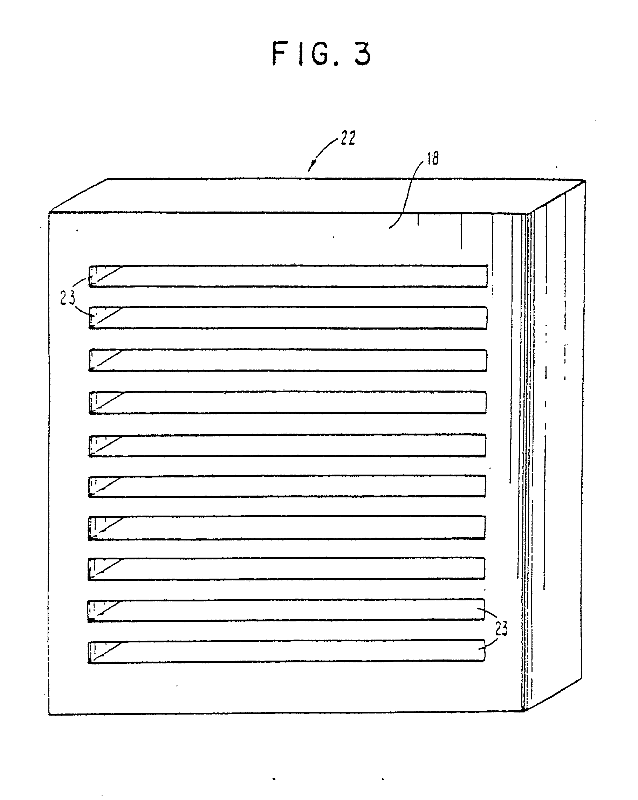

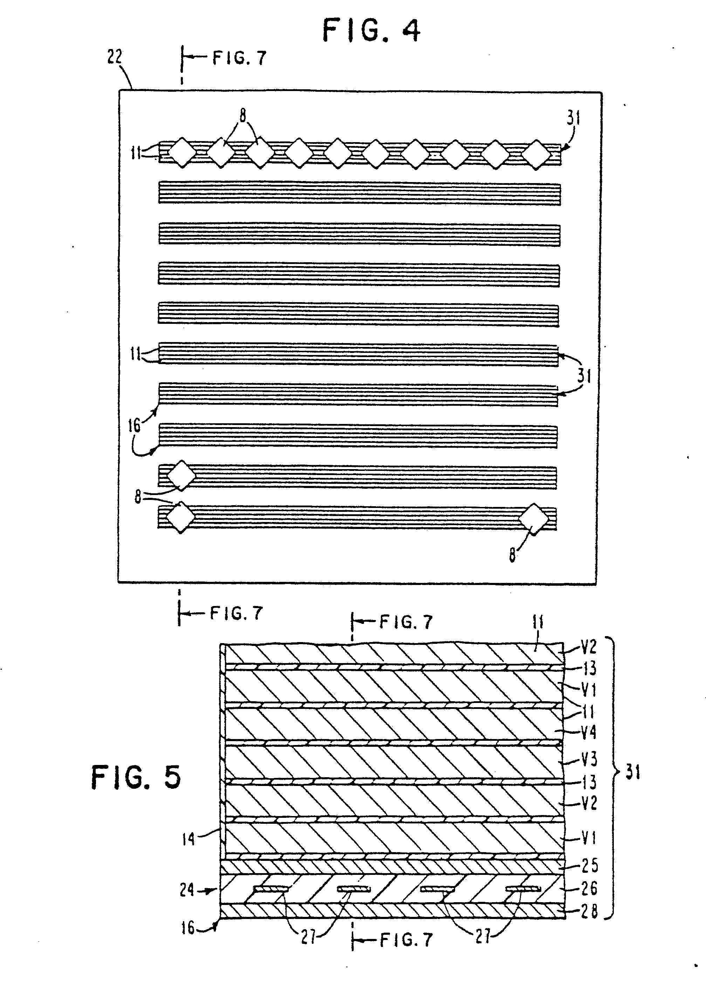

Beim Vereinigen von Mikrobausteinen oder Chips 8 mit kürzesten Schaltzeiten und sehr hohem Integrationsgrad (VLSI) zu einem kompakten Trägermodul 7 gemäss Fig. 1 ist es vor allem dringend notwendig, dass die Stromversorgungszuleitungen geringste Induktivität aufweisen, um den hohen Strombedarf der Chips 8 zu befriedigen. Der Chipträgermodul 7 von Fig. 1 besitzt ein Substrat 22 als mechanische Basis, auf dem die ganze Struktur des Moduls aufgebaut ist. Zusätzlich kann das Substrat 22 die wichtige elektrische Funktion einer Erdungs- und Bezugsebene übernehmen. Das Substrat 22 ist in Fig. 3 in perspektivischer Ansicht dargestellt und lässt zehn gefräste Schlitze 23 erkennen, die seine Dicke durchbrechen. In jeden Schlitz 23 wird ein Stapel 10 übereinandergeschichteter Leiterplatten 11 mit dielektrischen Isolationsschichten 13 und einem abgeschirmten Flachkabel 24, wie in Fig. 5 abgebildet, eingeführt. Jeder Stapel 10 umfasst zwölf geschichtete Leiterplatten 11 ausser dem abgeschirmten Flachleiterkabel 24 und reicht durch den Schlitz 23 hindurch.

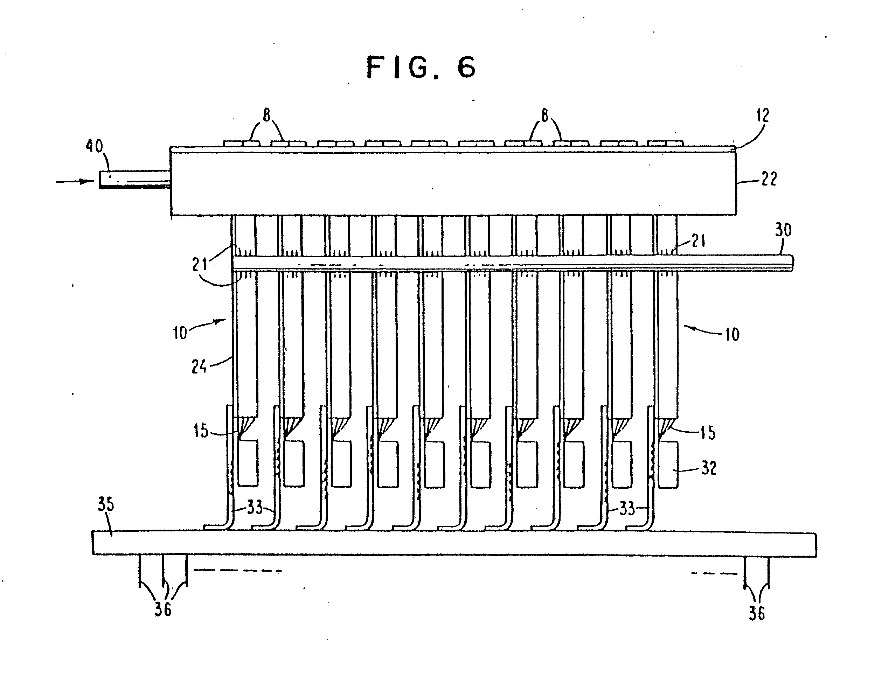

Jede Leiterplatte 11, die in den Fig. 2A und 2B abgebildet sind, besitzt eine Anschlussfahne 21 für die Verbindung mit Gleichstromversorgungsschienen 30, von denen zwecks Vereinfachung nur eine abgebildet ist, und weitere Anschlussfahnen 15 für Entkopplungskondensatoren 32, wie sie Fig. 6 zeigt. Die Leiterplatten 11 sind mit verschiedenen Stromversorgungsschienen 30 mittels gestaffelt angeordneter Anschlussfahnen 21 verbunden, deren Mehrzahl aber zur Vereinfachung der Abbildung nicht dargestellt ist. Diese Stapel 10 sind fest in das Substrat 22 eingelassen und stecken darin in starrer, mechanischer Verbindung. Elektrisch sind sie jedoch gegen Gleichstrom isoliert. Die grossen parallelen Oberflächen der Leiterplatten 11 ergeben sehr grosse gegenseitige Kapazitätswerte, die mit geringsten Werten induktiver Kopplung einhergehen. Die einzelnen Stapel 10 sind je nach Anforderungen der Chips 8 individuell an verschiedene Stromversorgungsschienen 30 angeschlossen.

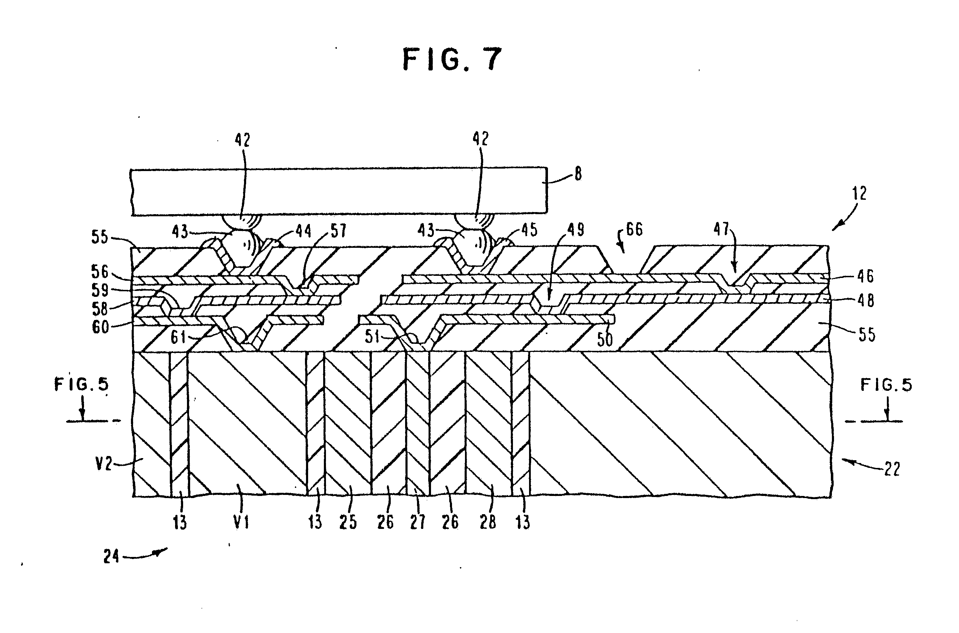

Auf der ebenen, metallischen Oberfläche 18 des Substrats, das durch Bearbeitung flach gestaltet worden ist, werden Kontaktschichten 12, vorzugsweise in Form von Verbindungsleitungen 41, in Dünnfilmtechnik und in mehreren Schichten aufgebracht, wie dies Fig. 7 im einzelnen deutlich zeigt. Das Substrat 22 von Fig. 3 ist ausgehend von einer Metallplatte mit etwa 90 mm im Quadrat und 12 mm Dicke hergestellt, und es sind zehn Schlitze 23 hindurchgefräst worden. Jeder Schlitz 23 besitzt zwei Flächen, die gemessen von einer Bezugsposition mit einer Genauigkeit von $2,5 \cdot 10^{-2}$ mm angelegt sind. Die Schlitze sind etwa 3,8 mm breit und liegen mit ihrer Mitte im Abstand von 7,6 mm nebeneinander.

Die Chips 8 liegen in einer Anordnung 10 × 10 Stück auf der Oberfläche des Substrats, wobei die vereinfachte Darstellung der Fig. 1 nur zwei Reihen mit geringerer Anzahl zeigt. Die Fig. 4 dagegen ist eine viel bessere Ansicht der tatsächlich bevorzugten Ausführung. Gemäss Fig. 5 ist das Flachleiterkabel 24 in der Ecke 16 befestigt, die von den zwei mit grosser Genauigkeit gefrästen Flächen gebildet wird. Dadurch sind die im Kabel enthaltenen Leiter ebenfalls auf $2,5 \cdot 10^{-2}$ mm Genauigkeit festgelegt. Die einzelnen Leiterplatten 11 sind rund 0,25 mm dick und besitzen eine Isolation 13 von etwa $1,2 \cdot 10^{-2}$ mm Dicke. Die Chipverbindungskontakte (42 in Fig. 7) mit Lotkügelchen (C-4) besitzen auf dem Chip 8 einen Abstand Mitte zu Mitte von beispielsweise 0,19 mm. Wenn aber der Chip um 45° gedreht ist, dann liegt etwa die Hälfe der C-4-Kontaktpunkte genau über den Leiterplatten 11, so dass auf Wunsch eine direkte Verbindung zwischen den Lotkugelkontakten und den Oberkanten 31 der Leiterplatten 11 hergestellt werden kann. Das Flachleiterkabel 24 jedoch wird mit den Dünnfilmkontaktschichten von Fig. 7 verbunden, die als Toleranz für das Ausrichten ein Mehrfaches von $2,5 \cdot 10^{-2}$ mm zulassen.

In Fig. 5 ist die Vergrösserung einer Ecke eines Schlitzes 23 abgebildet, welche von den zwei während der Bearbeitung genau angelegten Seitenflächen gebildet ist und bezüglich der die Lage des Leiterstapels 10 bestimmt und letzterer befestigt ist. Dies bestimmt auch die genaue Lage der Signalleiter 27, so dass sie mit den Kontaktschichten 12 verbunden werden können. Im Flachleiterkabel 24 sind die Leiter in der Isolation 26 eingebettet und liegen zwischen zwei abschirmenden Schichten 25 und 28. Einige oder alle Leiterplatten der Stromversorgung müssen vom Substrat 22, wie auch voneinander, durch eine Schicht 14 bzw. Schichten 13 isoliert werden. Solche Flachleiterkabel 24 sowie die Verfahren zu deren Verbindung mit anderen Kabeln und Steckern sind bekannt. Die Leiterstapel 10 können durch Glasierung oder durch andere Mittel mit dem Substrat 22 verkittet werden.

Gemäss der Fig. 6 ist jeweils ein Bandkabel 33 mit dem einen Ende des Flachleiterkabels 24 verbunden und dann an eine Signalverteilerplatte 35 angeschlossen. Diese besitzt an ihrer Unterseite Verbindungsstifte 36. Die verwendeten Bandkabel 33 können entweder starr oder biegsam sein. Das Metall der Leiter kann Kupfer sein oder ein Material, das bezüglich Ausdehnungskoeffizient angepasst ist, wie noch zu besprechen sein wird.

Aus den Fig. 2A und 2B ist zu ersehen, dass die Leiterplatten 11 Anschlussfahnen 21 für die Verbindung mit einer Gleichstromschiene 30 besitzen. Zusätzlich können Anschlussfahnen 15 vorhanden sein, die der Verbindung mit Entkopplungskondensatoren am unteren Ende der Leiterplatten dienen. Vorzugsweise ist ein Satz von vier Leiterplatten 11 V1 bis V4 angeordnet, die sich abwechseln, wie Fig. 5 zeigt. Dadurch kämen die Anschlussfahnen 15 und 21 jedes Typs von Leiterplatte 11 je in eine bestimmte Position zu liegen. Auf der Rückseite würde zudem das Flachleiterkabel 24 in einer Lötverbindung enden und in ein flexibles Bandkabel üblicher Art übergehen. Letzteres könnte, sofern es genügend biegsam ist, wie in der Fig. 6 gezeigt, um 90° abgebogen und mit einer gedruckten Schaltungsplatte verbunden werden.

Diese Anordnung ergibt etwa 20 cm² Leiterfläche pro Chip und pro Sammelschiene 30. Dadurch kann eine Isolationsdicke von 10-25 μm verwendet werden, die leicht herstellbar ist und gleichzeitig genügend Kapazität zwischen den Platten ergibt, um die unerwünschten, hochfrequenten Einschwingvorgänge an den Stromversorgungspunkten zu den Chips 8 zu unterdrücken. Ausserdem besitzen die Leiterplatten 11 vorgefertigte Oberflächen, so dass die Öffnung eines Feinlunkers der Isolationsschicht 13 nicht unbedingt einen Kurzschluss verursacht. Dies wäre der Fall, wenn die Struktur durch aufeinanderfolgendes und alternierendes Aufbringen von Leiter- und Isolationsschichten, beispielsweise durch Aufdampfen im Vakuum, aufgebaut würde. Die abgebildeten Entkopplungskondensatoren 32 kommen zu den Kapazitäten von etwa 1 μF, die zwischen den durch das Dielektrikum 13 getrennten Leiterplatten 11 vorhanden sind, noch hinzu, und wirken vor allem gegen langsame Einschwingvorgänge. Es ergibt sich durch sie aber auch eine Dämpfung höherer Frequenzen. Um in einem Bandkabel 33 etwa 160-200 Signalleiter führen zu können, werden letztere in einem Abstand Mitte zu Mitte von 0,5 mm angeordnet. Unter diesen Umständen können die Verbindungen leicht, z.B. durch Fliesslöten, hergestellt werden.

Der Chipträgermodul 7 sollte thermisch den Chips 8 angepasst sein. Daher ist die Verwendung von Molybdän für das Substrat 22 in Betracht gezogen worden. Dies basiert allerdings auf der Annahme, dass der Träger dieselbe Temperatur wie das Silizium erreicht, was aber nur bei thermisch schlechten Leitern zutrifft. Gemäss Fig. 6 führt eine Kühlmittelleitung 40 in das Substrat 22 hinein. Es müssen also im Substrat 22 Kühlmittelkanäle hergestellt werden. Den Temperaturanstieg kann man steuern, wodurch die Verwendung von Metallen mit grossem Ausdehnungskoeffizient ermöglicht wird, so z.B. Kupfer oder Messing, die leichter bearbeitbar sind. Als Alternative kann der Metallblock auch gekühlt werden, um die Ausdehnung annähernd auf null zu halten. Alle Verbindungen mit einem Chip 8 können über die dünnen Kontaktschichten 12 geführt werden. Wird jede dieser Leitungen wenigstens mit einer Biegung von 90° versehen, dann kann die thermische Ausdehnung von Silizium von ca. 1 µm leicht durch die Biegsamkeit der Kupferleitung und der organischen Isolation aufgenommen werden. Es entstehen so keine Beanspruchung der C-4-Kontaktpunkte und kein Ermüdungsproblem.

Die Fig. 7 zeigt den Plan der Struktur wirklicher Verbindungsleitungen, die, in Kontaktschichten 12 eingeschlossen, zur Verwendung kommen und, wie in Fig. 6 abgebildet, auf der ebenen Metalloberfläche aufgebracht werden. Der Chip 8 ruht auf der Kontaktschicht 12. Er ist äusserlich durch C-4-Lotkügelchen 42 getragen und mit ebensolchen Lotkügelchen 43 verbunden, die auf Schichtdurchführungen 44 und 45 sitzen. Letztere sind in konischen Durchbrüchen der obersten der Kontaktschichten 12 hergerichtet worden. Die Durchführung 45 verbindet über einen V-förmigen Leiter hinunter zu einer oberen, verlustbehafteten Übertragungsleitung 46. Diese Leitung erstreckt sich, über eine weitere Durchführung 47, über den rechten Rand der Darstellung hinaus bis zu einer oder mehreren Durchführungen, die mit anderen Chips verbunden und ähnlich ausgeführt sind. Unterhalb der Leitung 46 ist eine weitere Leitung 48 ebenfalls mit der Durchführung 47 verbunden. Zur Vereinfachung der Darstellung ist die verlustbehaftete Leitung 48 direkt unter der Leitung 46 gezeichnet worden, obwohl sie sich vorzugsweise senkrecht zur Zeichnungsebene fortsetzen würde. Darunter jedoch läge die Leitung 50, die über die Durchführung 49 mit der Leitung 48 verbunden ist, und sie würde sich vorzugsweise aber nicht notwendigerweise, wie dargestellt, parallel zur Leitung 46 erstrecken. Diese Anordnung würde sich also für ein nach rechtwinkligen x-, y-Koordinaten geordnetes System eignen, wobei sich Leitungen in der x-Richtung auf der Höhe der Leitung 48, solche in der y-Richtung auf der Höhe der Leitung 50, befinden. Das oberste Niveau einschliesslich der Leitung 46 würde eine Schicht zur Durchführung von Tests und technischen Änderungen darstellen. In dieser könnten Öffnungen 66, von denen nur eine einzige abgebildet ist, dazu dienen, z.B. mit einem Laserstrahl, in bekannter Art Verbindungen durchzutrennen usw. Die Übertragungsleitungen 56, 58 und 60 sowie die Durchführungen 57, 59 und 61 verbinden ein C-4-Lotkügelchen 43 mit der Leiterplatte V1.

In der Fig. 7 sind die Einzelschichten der Kontaktschichten 12 zur Verdeutlichung in der vertikalen Richtung stark vergrössert dargestellt. In Wirklichkeit kann die Durchführung 44 möglicherweise direkt in Kontakt mit der Leiterplatte V1 hergestellt werden. Die Lotkügelchen 42 und 43 sind übrigens im Zustand dargestellt, wenn sie zu verschmelzen beginnen. Nach der Fliesslötung erscheinen sie dann als ein einziges, grösseres Kügelchen.

Die Leitungen 46, 48 und 50, wie auch 56, 58 und 60, sind in ein Dielektrikum 55 eingebettet, das vorzugsweise aus einem Polyimid, Kunststoff oder Glas besteht und gleichzeitig isoliert und trägt. Die unterste Leitung 50 steht elektrisch über die Durchführung 51 mit dem Leiter 27 des Flachleiterkabels 24 in Kontakt (s. Fig. 5). Die Leitungen 46, 48 und 50 stellen mit Bezug auf die Erdungsebene 22 einzelne, verlustbehaftete Streifenleitungen dar, die ausgelegt sind, um Signalimpulse mit hoher Geschwindigkeit zu übertragen und gleichzeitig Reflexionen zu dämpfen.

Die Leiterplatte V1, welche als Durchleitung durch die Oberfläche des Substrats 22 verwendet wird, beliefert die Leitungen 56, 58, 60 usw. mit Strom, dank ihres Schichtaufbaus, über ein Minimum an Induktivität. Sie kann daher für den Baustein sowohl Eingangs- als auch Ausgangssignale führen. Mit dieser Anordnung kann höhere Verdrahtungsdichte für die Leitungen 46, 48, 50, wie auch 56, 58 und 60, erzielt werden, da diese sehr schmal ausgeführt werden können. Die Dünnfilmstruktur der Leitung ermöglicht die Weiterleitung des Stromes über das Substrat 22 und diese Leitung fast ohne zusätzliche Induktivität.

Es ist zu beachten, dass die Leitungen 46, 48, 50 usw., zusammen mit der Erdungs- und Bezugsebene des Substrats 22 betrachtet, wie Fig. 7 zeigt, dünnschichtige Übertragungsleitungen vom Typus der sog. *strip lines* bilden. Diese Anordnungen werden unter Einsatz der üblichen Technik für das Niederschlagen dünner Schichten mittels Photolack und photolithographischer Maskierung, die bei der Fabrikation von VLSI-Chips angewandt wird, in Serie hergestellt. Dabei kann der Niederschlag auch im Vakuum durch Aufdampfen, Aufsprühen, oder aber durch galvanisches Plattieren, u.ä. erzielt werden, was die Herstellung eines Moduls 7 sehr erleichtert.

Beim Aufbau der Struktur gemäss Fig. 7 werden die Metallisierungen und Durchführungen in aufeinanderfolgenden Schichten, Schicht um Schicht und schrittweise, aufgebaut. Wenn beispielsweise die Metallisierung der Leitung 50 in der x-Richtung auf eine Schicht Dielektrikum 55 aufgebracht wird, dann geschieht dies, nachdem in einem vorausgehenden Schritt eine Öffnung für eine Durchführung hergestellt worden ist. Danach wird die Metallisierung 50 mit weiterem dielektrischem Material 55 bedeckt und es folgt das Aufbringen der Metallisierung 48 in der y-Richtung usw.

Die in Zeichnungen dargestellte Ausführung zeigt für den Modul mit Substrat 22 und Flachleiterkabel 24 nur einen homogenen, metallischen Block. Als Substrat 22 kann aber offensichtlich ebensogut ein metallbeschichteter Isolator verwendet werden. Ausserdem lässt es die Flexibilität der Anordnung der Kontaktschichten 12 zu, auch konventionelle Stiftkontakte zu verwenden, um Signale aus dem Modul 7 auszukoppeln.

**Patentansprüche**

1. Modul für Schaltungschips (8) umfassend ein Substrat (22) mit planparallelen Oberflächen, eine Anzahl von Schichtleiterstapeln (10) für die

Stromzufuhr und eine Anzahl von dem Niveau einer ersten planparallelen Oberfläche (18) benachbarten Anschlussflächen (31) zur Verbindungsherstellung zu dem Schaltungschips (8), bei dem die Schichtleiterstapel aus einer Vielzahl flacher, metallischer Leiterplatten (11) bestehen, die voneinander durch ein Dielektrikum (13) getrennt sind, und gegeneinander eine grosse Kapazität sowie geringe induktive Kopplung aufweisen, dadurch gekennzeichnet, dass die planparallelen Oberflächen des Substrats (22) von wenigstens einem Schlitz (23) durchbrochen sind, dass in dem Schlitz ein Schichtleiterstapel (10) steckt, dessen Leiterplatten (11) ganz durch den Schlitz hindurch reichen, so dass die hindurchreichenden Kanten der Leiterplatten (11) eines Schichtleiterstapels (10) jeweils eine der Anschlussflächen (13) bilden, und dass wenigstens einige der genannten Leiterplatten (11) elektrisch vom Substrat (22) isoliert sind.

2. Modul nach Anspruch 1, dadurch gekennzeichnet, dass der genannte Schichtleiterstapel (10) sich wesentlich über die zweite der planparallelen Oberflächen des Substrats (22) hinaus erstreckt, jener Oberfläche, die den Schaltungschips (8) abgewendet ist.

3. Modul nach Anspruch 1, dadurch gekennzeichnet, dass einzelne Leiterplatten (11) des Schichtleiterstapels mit Anschlussfahnen (21) für die Verbindung mit Stromsammelschienen (30) ausgerüstet sind.

4. Modul nach Anspruch 2, dadurch gekennzeichnet, dass an einzelnen Leiterplatten (11) weitere Anschlussfahnen (15) für die Verbindung mit Entkopplungskondensatoren (32) vorhanden sind.

5. Modul nach Anspruch 1, dadurch gekennzeichnet, dass das genannte Substrat (22) aus Metall ist und eine Anzahl paralleler Schlitze (23) aufweist, ferner, dass in letzteren, dielektrisch isoliert, je ein Schichtleiterstapel (10) und je ein mehradriges Flachleiterkabel (24) stecken, dessen Adern (27) für Zu- und Ableitung schwacher Wechselstromsignale durch die Schlitze hindurch vorgesehen sind.

6. Modul nach Anspruch 1, dadurch gekennzeichnet, dass zusätzliche Kontaktschichten (12) zur Verbindung der genannten Leiterplatten (11) mit den Schaltungschips (8) vorgesehen sind.

## Claims

1. Module for circuit chips (8) comprising a substrate (22) with opposed parallel, planar surfaces, a plurality of stacked laminated conduc-. tors (10) for the power supply, and a plurality of land areas (31) on a level adjacent to that of a first of the planar surfaces (18) for interconnection to the circuit chips (8), the stacked laminated conductors consisting of a plurality of flat, metallic sheet conductors (11), separated from one another by a dielectric (13) and having a high capacitance and low inductance between them, characterized in that the parallel, planar surfaces of the substrate (22) comprise at least one slot (23) containing a stack of the laminated conductors (10), the sheet conductors (11) of which extend entirely through the slot so that the edges of the sheet conductors (11) of the stack of conductors (10) form one of the land areas (31), and that at least some of the sheet conductors (11) are electrically insulated from the substrate (22).

2. Module according to claim 1, characterized in that said stack of conductors (10) extends essentially beyond the second one of the parallel, planar surfaces of the substrate (22), that is, the surface looking away from the circuit chips (8).

3. Module according to claim 1, characterized in that some of the sheet conductors (11) of the stack of conductors are provided with connection tabs (21) for interconnection to power bar rods (30).

4. Module according to claim 2, characterized in that some of the sheet conductors (11) are provided with additional connection tabs (15) for interconnection to decoupling capacitors (32).

5. Module according to claim 1, characterized in that said substrate (22) consists of metal and has a plurality of parallel slots (23), further in that a stack of conductors (10) and multiple-wire ribbon conductor (24) are inserted in each of the slots in a dielectrically insulated fashion, the wires (27) of the ribbon conductor being provided for supplying weak a.c. signals through the slots.

6. Module according to claim 1, characterized in that additional interconnection layers (12) are provided for interconnecting said sheet conductors (11) with the circuit chips (8).

## Revendications

1. Module pour des microplaquettes à circuits intégrés (8) comportant un substrat (22) ayant des surfaces planes parallèles, plusieurs piles de conducteurs stratifiés (10) pour l'alimentation en courant, et plusieurs zones de connexion (31) adjacentes à une première desdites surfaces (18) planes pour établir une connexion à la microplaquette à circuits intégrés (8), dans lequel les piles de conducteurs stratifiés sont composées de plusieurs plaques conductrices métalliques plates (11) séparées les unes des autres par un diélectrique (13) et ayant, les unes par rapport aux autres, une capacité élevée et une inductance faible, caractérisé en ce que les surfaces planes parallèles du substrat (22) comportent au moins une fente (23), en ce qu'une pile de conducteurs stratifiés (10) est insérée dans ladite fente, les plaques conductrices (11) de cette pile traversant cette fente complètement, de telle sorte que les bords des plaques conductrices (11) d'une pile de conducteurs stratifiés (10) forment une des surfaces de connexion (31) et en ce qu'au moins quelques-unes desdites plaques conductrices (11) sont isolées électriquement du substrat (22).

2. Module selon la revendication 1, caractérisé en ce que ladite pile de conducteurs stratifiés (10) s'étend essentiellement au-delà de la seconde des surfaces planes parallèles du substrat (22), c'est-à-dire la surface qui ne fait pas face aux microplaquettes à circuits intégrés (8).

3. Module selon la revendication 1, caractérisé en ce que certaines plaques conductrices (11) de la pile de conducteurs stratifiés comportent des plots de connexion (21) pour établir la connexion avec des guides de courant (30).

4. Module selon la revendication 2, caractérisé en ce que certaines plaques conductrices (11) sont équipées d'autres plots de connexion (15) pour être connectées à des condensateurs de découplage (32).

5. Module selon la revendication 1, caractérisé en ce que ledit substrat (22) est en métal et comporte plusieurs fentes parallèles (23), et en ce que dans chacune de ces fentes sont enfichés, diélectriquement isolés, une pile de conducteurs stratifiés (10) et un câble plat multifils (24) dont les fils (27) sont conçus de façon à transmettre et à recevoir des signaux de courant alternatif faible à travers ces fentes.

6. Module selon la revendication 1, caractérisé en ce que des couches de contact supplémentaires (12) sont prévues pour connecter lesdites plaques conductrices (11) aux microplaquettes à circuits intégrés (8).

# FIG. 1

# FIG. 2A

# FIG. 2B

# FIG. 3

# FIG. 4

# FIG. 5

FIG. 6

# FIG. 7

0 022 176